# EUROPÄISCHE PATENTSCHRIFT

(11) **EP 2 482 081 B1**
(45) Veröffentlichungstag und Bekanntmachung des Hinweises auf die Patenterteilung: **07.12.2016**
(21) Anmeldenummer: 12153044.8
(22) Anmeldetag: 30.01.2012
(51) Int. Cl.: G01R 11/04

(54) **Anschlussvorrichtung für einen Stromzähler**
Connector device for an electricity meter
Dispositif de raccordement pour un compteur d'électricité

(30) Priorität: 31.01.2011 DE 102011009904; 12.10.2011 DE 102011054412
(43) Veröffentlichungstag der Anmeldung: 01.08.2012
(73) Patentinhaber: Hager Electro GmbH & Co. KG, 66440 Blieskastel (DE)
(72) Erfinder:
(74) Vertreter: Nuss, Laurent

(56) Entgegenhaltungen:
- EP-A1- 2 267 462
- EP-A2- 1 640 731
- EP-A2- 1 901 078
- EP-A2- 2 221 584
- DE-A1-102004 002 856
- DE-U1-202010 016 085
- GB-A- 2 325 747
- US-A- 6 152 764

## Beschreibung

Die Erfindung betrifft eine Anschlussvorrichtung für einen Stromzähler, insbesondere einen elektronischen Stromzähler), die eine Befestigungs- und Kontaktiereinrichtung mit einem länglichen, eine Zählertragplatte zur Aufnahme des Stromzählers aufweisenden Gehäuse umfasst, wobei in dem Gehäuse Anschlusselemente für eine ein einzige oder mehrere Stromphasen zur elektrischen Verbindung mit von dem Stromzähler durch Öffnungen in der Zählertragplatte vorstehenden Kontaktstücken angeordnet sind.

Durch Benutzung sind Anschlussvorrichtungen zur Aufnahme von elektronischen Stromzählern für die Messung von Dreiphasenwechselstrom bekannt. Sie weisen in einem länglichen Gehäuse Anschlusselemente für die Stromphasen L1, L2 und L3 und für den Neutralleiter des Dreiphasenwechselstroms auf und sind, wie aus den Patentanmeldungen DE 10 2004 002 856 A1 und EP 1 901 078 A2 bekannt ist, in der Anschlussvorrichtung verteilt und versetzt zueinander angeordnet.

Während in Deutschland durch die Energieversorger hauptsächlich Dreiphasenwechselstrom zur Verfügung gestellt wird und nur ein verhältnismäßig geringer Anteil von 15 % der Verbraucher mit Einphasenwechselstrom versorgt wird, wird in mehreren europäischen Ländern wie Frankreich, Großbritannien oder Griechenland ein großer Teil der Verbraucher mit Einphasenwechselstrom versorgt. Zwar ist mit den bekannten Anschlussvorrichtungen und Stromzählern auch die Messung des Energieverbrauchs bei Versorgung mit Einphasenwechselstrom möglich. Es erscheint aber sinnvoll, die Anschlussvorrichtungen und die Stromzähler besser an die zur Messung von Einphasenwechselstrom gestellten Anforderungen anzupassen.

Eine Anschlussvorrichtung der eingangs genannten Art geht aus der GB 2 325 747 A hervor. Die Anschlussvorrichtung umfasst eine Befestigungs- und Kontakteinrichtung mit einem länglichen, eine Zählertragplatte aufweisenden Gehäuse, in dem Anschlusselemente für eine Stromphase untergebracht sind. Eine seitlich von dem länglichen Gehäuse abstehender Gehäuseansatz weist ein Anschlusselement für einen Neutralleiter auf. Eine einen Stromzähler und einen Sicherungsschalter umfassende Baueinheit ist an die Befestigungs- und Kontaktiereinrichtung koppelbar, wobei ein Neutralleiteranschluss mit dem Gehäuseansatz und Phasenleiteranschlüsse mit dem länglichen Gehäuse in Verbindung kommen.

Der Erfindung die Aufgabe zugrunde, eine neue Anschlussvorrichtung und einen Stromzähler zu schaffen, die bzw. der den für die Zählung von einphasigem Wechsel-strom bestehenden Anforderungen besser gerecht wird.

Die diese Aufgabe lösende Anschlussvorrichtung nach der Erfindung ist dadurch gekennzeichnet dass in dem länglichen Gehäuse ferner ein Anschlusselement für den Neutralleiter und in der Trägerplatte eine entsprechende Öffnung für ein vom Stromzähler vorstehendes Kontaktstück vorgesehen ist, dass die Kontaktstücke durch Verschiebung des Stromzählers auf der Tragplatte in Längsrichtung des Gehäuses oder senkrecht dazu mit den Anschlusselementen verbindbar sind, dass das längliche Gehäuse Einrichtungen zur Anbringung des länglichen Gehäuses am horizontalen Schenkel eines Zählerkreuzes einer Zählerplatzbaueinheit oder an einer Hutprofilschiene mit einer Längsseite parallel zu dem Schenkel bzw. der Hutprofilschiene aufweist und dass in der Alternative mit Anschlusselementen für mehrere Stromphasen die Zählertragplatte jedoch nur Öffnungen zur Nutzung von Anschlusselementen einer einzigen Stromphase aufweist.

In einer ersten Variante der Erfindung wird die Aufgabe dadurch gelöst, dass lediglich ein einziges Stromphasenanschlusselement vorgesehen ist und das Stromphasenanschlusselement und das Neutralleiteranschlusselement in der Anschlussvorrichtung platzsparend angeordnet sind.

Da zur Messung von Einphasenwechselstrom lediglich eine einzige Stromphase kontaktiert werden muss und am Stromzähler nur Kontaktstücke für die Kontaktierung eines einzigen Stromphasenanschlusselements vorgesehen sein müssen, wird es durch die platzsparende Anordnung der Anschlusselemente möglich, die Anschlussvorrichtung selbst deutlich kleiner zu gestalten und darüber hinaus den Energieverbrauch mit einem Stromzähler zu messen, der wesentlich kleiner als die bekannten Stromzähler ist.

Entsprechend verringern sich die Materialkosten für die Herstellung der Anschlussvorrichtung und des Stromzählers und am Zählerplatz steht mehr Raum zur Verfügung, der z.B. für andere Geräte genutzt werden kann.

In einer besonders bevorzugten Ausgestaltung der Erfindung sind das Stromphasenanschlusselement, das Neutralleiteranschlusselement und ggf. eine Datenschnittstelle zur Übertragung von Daten von oder zu dem Stromzähler zur Ermöglichung ihrer platzsparenden Anordnung in der Anschlussvorrichtung in einem länglichen Raumabschnitt in Längsrichtung des Raumabschnitts gesehen hintereinander angeordnet. Dadurch wird die Möglichkeit geschaffen, die Anschlussvorrichtung und den Stromzähler länglich und schmal auszubilden. Sie lassen sich an einem Rand eines Zählerplatzes anordnen, wodurch dort ein verhältnismäßig großer nutzbarer Raum entsteht.

In einer zweiten Variante umfasst die Anschlussvorrichtung mehrere, vorzugsweise drei, Stromphasenanschlusselemente und zumindest eines der Stromphasenanschlusselemente und das Neutralleiteranschlusselement sind in der Anschlussvorrichtung platzsparend angeordnet.

Diese Variante ist zur Installation insbesondere dann vorgesehen, wenn eine Möglichkeit zum Wechsel von einer Versorgung mit Einphasenwechselstrom auf eine Versorgung mit Dreiphasenwechselstrom oder umgekehrt bestehen soll.

In einer besonders bevorzugten Ausgestaltung der Erfindung sind zumindest das eine Stromphasenanschlusselement und das Neutralleiteranschlusselement in einem länglichen Raumabschnitt in Längsrichtung des Raumabschnitts gesehen hintereinander und/oder unter Freilassung eines Raumbereichs der Anschlussvorrichtung zusammen an einer Seite oder in einem Eckbereich der Anschlussvorrichtung angeordnet.

Wird eine solche Anschlussvorrichtung für die Messung von Einphasenwechselstrom genutzt, braucht der Stromzähler lediglich Kontaktstücke zur Kontaktierung eines einzigen Stromphasenanschlusselements aufzuweisen und kann bei erfindungsgemäßer Anordnung der Anschlusselemente und ggf. der Datenschnittstelle entsprechend klein sein. Auch bei dieser Variante reduzieren sich die Materialkosten für den Stromzähler und auf der Tragplatte steht mehr Platz zur Verfügung.

Wird mit Dreiphasenwechselstrom versorgt, wird auf der Anschlussvorrichtung ein Stromzähler verwendet, der zur Kontaktierung der drei Phasen geeignet ist und entsprechend größer sein kann.

Es wird ein flexibles Anschlusssystem geschaffen, das sowohl der Nutzung für Einphasenwechselstrom als auch für Dreiphasenwechselstrom gerecht wird.

Zweckmäßigerweise können die Anschlusselemente und ggf. die Datenschnittstelle der ersten und der zweiten Variante dieselbe Größe aufweisen und in der Anschlussvorrichtung in derselben Art und Weise, insbesondere in identischen Abständen voneinander, angeordnet sein. Zur Messung des Energieverbrauchs bei Versorgungen mit Einphasenwechselstrom können dann für beide Varianten baugleiche Stromzähler verwendet werden.

Zweckmäßigerweise sind das Stromphasenanschlusselement, das Neutralleiteranschlusselement und die Datenschnittstelle in der Längsrichtung zueinander, zumindest im Wesentlichen, fluchtend angeordnet. Auf diese Weise kann eine Anschlussvorrichtung bzw. der Stromzähler zur Messung des Einphasenwechselstroms besonders schmal gebildet werden.

In einer Ausgestaltung der Erfindung weist das Stromphasenanschlusselement und vorzugsweise auch das Neutralleiteranschlusselement ein stromzu- und ein stromabführendes Anschlussteil auf. Eine besonders platzsparende Anordnung ergibt sich, wenn die Anschlussteile in der genannten Längsrichtung und/oder in Richtung entlang der genannten Seite der Anschlussvorrichtung gesehen hintereinander angeordnet sind. Zweckmäßigerweise können auch die Anschlussteile, zumindest im Wesentlichen, fluchtend zu dem Neutralleiteranschlusselement bzw. den Neutralleiteranschlussteilen angeordnet sein.

Zweckmäßigerweise sind die Stromphasenanschlusselemente und ggf. das Neutralleiteranschlusselement mit einem Überbrückungsteil versehen, das eine die Anschlussteile überbrückende Stellung und eine Offenstellung aufweist. Das Überbrückungsteil wird in die überbrückende Stellung gebracht, wenn z.B. während Wartungs- oder Installationsarbeiten der Stromzähler abgenommen wird und sichergestellt sein soll, dass der Verbraucher weiter mit Strom versorgt ist. Das Überbrückungsteil wird in die Offenstellung gebracht entweder, wenn der Stromzähler angeschlossen ist und den Energieverbrauch misst, oder wenn bei nicht installiertem Stromzähler eine Stromentnahme verhindert werden soll.

Zweckmäßigerweise weist die Anschlussvorrichtung eine Tragplatte auf, gegen die ein Gehäuse des Stromzählers anzulegen ist und die Öffnungen aufweist, durch die die Kontaktstücke des Stromzählers zu führen sind.

In einer weiteren Ausgestaltung der Erfindung ist die Anschlussvorrichtung mit einem parallel zur Tragplatte bewegbaren, Öffnungen aufweisenden Schieber versehen, dessen Öffnung in einer ersten Stellung des Schiebers zu den Öffnungen in der Tragplatte ausgerichtet sind und der in einer zweiten Stellung die Öffnungen der Tragplatte verschließt. Ein solcher Schieber und die dazu passende Ausgestaltung der Anschlussvorrichtung ist aus der DE 2004 002 856 11 bekannt.

In der ersten Stellung kann der Zähler auf die Tragplatte aufgesetzt werden, wobei die Kontaktstücke die Öffnungen sowohl in der Tragplatte als auch im Schieber durchdringen können. Bei abgenommenem Zähler lässt sich der Schieber in die zweite Stellung verschieben, in welcher die Öffnungen in der Tragplatte durch den Schieber verschlossen sind. So lässt sich der Zugang zu hinter der Tragplatte angeordneten Anschlusselementen versperren.

Der Schieber ist vorzugsweise auf der dem Stromzähler abgewandten Seite der Tragplatte angeordnet. Der Schieber kann so innerhalb eines Gehäuses der Anschlussvorrichtung angeordnet sein und ist gegen Manipulation von außen geschützt.

Handelt es sich bei den Öffnungen in der Tragplatte um längliche Öffnungen, so ist der Schieber vorzugsweise quer zur Längsachse der Öffnungen von der ersten in die zweite Stellung bewegbar. In diesem Fall ist nur ein kurzer Verschiebungsweg erforderlich.

Diese Ausführungsform kommt insbesondere dann in Betracht, wenn gemäß der Erfindung die Kontaktstücke durch Verschiebung des Stromzählers auf der Tragplatte mit den Anschlusselementen verbindbar sind, wobei die Kontaktstücke, die gegen den Rand der Öffnung des Schiebers anliegen, den Schieber mitbewegen, welcher seinerseits Mitnehmer zur Mitbewegung des Überbrückungsteils aus der überbrückenden Stellung in die Offenstellung und umgekehrt aufweist. Kontaktstücke können sich dann innerhalb der länglichen Öffnungen in der Tragplatte entsprechend der Länge des Verschiebungswegs bewegen.

Zweckmäßigerweise sind die Kontaktstücke durch Verschiebung in der genannten Längsrichtung oder entlang der genannten Seite oder senkrecht dazu mit den Anschlusselementen verbindbar.

In einer weiteren Ausgestaltung der Erfindung kann das Überbrückungsteil, wie es aus der DE 2004 002 865 A1 bekannt ist, ein länglicher Blechstreifen sein, der eine Randausnehmung aufweist, in welche eines der Kontaktstücke ohne elektrischen Kontakt zu dem Überbrückungsteil eingreift. In diesem Fall können platzsparend ein streifenförmiges Kontaktstück und das Überbrückungsteil in der Verschiebungsrichtung zueinander fluchtend angeordnet sein.

Zweckmäßigerweise ist in einer solchen Konstruktion der Schieber durch die Kontaktstücke in einer Richtung senkrecht zur Richtung der Bewegung des Schiebers von der ersten in die zweite Stellung bewegbar. In einer weiteren Ausführungsform der Erfindung sind die Öffnungen im Schieber derart gestaltet, dass in einer dritten Stellung des Schiebers das betreffende Kontaktstück sich bei Verschiebung des Stromzählers auf der Tragplatte in dieser Öffnung, ohne den Schieber mitzubewegen, frei bewegen kann. Vorteilhaft lässt sich der Anschlussvorrichtung dann wahlweise mit oder ohne Nutzung des Überbrückungsteils verwenden.

Zweckmäßigerweise lässt sich der Schieber in der zweiten und/oder dritten Stellung arretieren und die Arretierung ist vorzugsweise plombierbar. Manipulationen an der Anschlussvorrichtung bei abgenommenem Zähler sind ausgeschlossen.

Eine weitere Ausführungsform der Erfindung betrifft eine Befestigungs- und Kontaktiervorrichtung zum Anschluss eines Stromzählers, insbesondere elektronischen Stromzählers, wobei von dem Stromzähler in Richtung senkrecht zu einer Zählertragplatte der Befestigungs- und Kontaktiervorrichtung durch Öffnungen in der Zählertragplatte vorstehende Anschlusskontakte mit Anschlusselementen der Befestigungs- und Kontaktiervorrichtung verbindbar sind.

Eine solche Befestigungs- und Kontaktiervorrichtung ist aus der EP 1431 765 A1 bekannt. Sie dient der Aufnahme eines dreiphasigen elektronischen Stromzählers. Ein durch die Zählertragplatte abgedecktes Gehäuse der Befestigungs- und Kontaktiervorrichtung weist Einrichtungen zur Anbringung der Befestigungs- und Kontaktiervorrichtung an einem Zählerkreuz einer Zählerplatzbaugruppe für den Anschluss eines herkömmlichen elektromechanischen Stromzählers auf.

Diese besonders platzsparende Anordnung ermöglicht die Anbringung weiterer Geräte an dem Zählerkreuz der Zählerplatzbaugruppe bzw. die Unterbringung der Befestigungs- und Kontaktiervorrichtung z.B. innerhalb einer Verteilereinrichtung.

Vorteilhaft lässt sich die Befestigungs- und Kontaktiervorrichtung für die Aufnahme eines einphasigen Stromzählers ggf. allein am horizontalen Schenkel des Zählerkreuzes anbringen.

Die genannten Einrichtungen zur Anbringung der Befestigungs- und Kontaktiervorrichtung an dem horizontalen Schenkel des Zählerkreuzes umfassen vorzugsweise vertikale Einschlitzungen im Boden des Gehäuses. Die Befestigungs- und Kontaktiervorrichtung lässt sich so z.B. von oben her auf Schraubhalterungen aufschieben, die mit dem horizontalen Schenkel verbunden sind.

Zweckmäßig stehen die obengenannten Anschlusselemente in Verbindung mit Klemmen, die der Verbindung der Befestigungs- und Kontaktiervorrichtung mit von unten zugeführten Stromkabeln dienen. Vorteilhaft können die zum Anschluss des herkömmlichen elektromechanischen Stromzählers von unten herangeführten Stromkabel auch mit der erfindungsgemäßen Befestigungs- und Kontaktiervorrichtung verbunden werden.

In weiterer Ausgestaltung der Erfindung stehen die Anschlusselemente mit Klemmen zur Verbindung der Befestigungs- und Kontaktiervorrichtung mit von oben zugeführten Leitungen zum Abgreifen von Spannungen in Verbindung. Zweckmäßig können wahlweise gezählten oder ungezählten Strom liefernde Anschlusspaare genutzt werden, um z.B. zusätzliche Geräte, insbesondere Kommunikationsgeräte, mit einer Betriebsspannung zu versorgen.

In einer bevorzugten Ausführungsform der Erfindung weisen Anschlusselemente, insbesondere die spannungsführenden Anschlusselemente, eine am Boden des Gehäuses durch Bodenvorsprünge gegen Verschiebung gesicherte Grundplatte mit Abwinklungen für die Bildung von Kontaktiereinrichtungen, insbesondere einer Anschlussklemme und eines Kontaktschenkels, auf.

In der vorangehend genannten bevorzugten Ausführungsform umfasst ein Anschlusselement für den Neutralleiter ein an dem Gehäuse festgelegtes Drahtstück, von dem vorzugsweise ein Endabschnitt zur Bildung einer mit dem betreffenden Kontaktelement des Stromzählers verbindbaren Kontaktfahne vorgesehen ist. Alternativ könnte auch das Anschlusselement für den Neutralleiter, wie die oben beschriebenen spannungsführenden Anschlusselemente, aus einem gebogenen Blechstanzteil mit einer Grundplatte hergestellt sein.

Zweckmäßig sind die Grundplatten der spannungsführenden Anschlusselemente durch einen vom Boden des Gehäuses vorspringenden isolierenden Steg voneinander getrennt.

In weiterer vorteilhafter Ausgestaltung der Erfindung ist der Stromzähler auf der Befestigungs- und Kontaktiervorrichtung in deren Längsrichtung unter Verbindung der Kontaktelemente des Stromzählers mit den Anschlusselementen der Befestigungs- und Kontaktiervorrichtung verschiebbar. Zweckmäßig erfolgt also die Verschiebung entlang des Schenkels des Zählerkreuzes bzw. in Längsrichtung entlang der Hutprofilschiene.

In einer weiteren bevorzugten Ausführungsform der Erfindung ist eine die Verschiebung des Stromzählers aus einer Anschlussposition verhindernde, vorzugsweise ein Steckschloss umfassende Verschlusseinrichtung vorgesehen.

Die Befestigungs- und Kontaktiervorrichtung kann, vorzugsweise einstückig über ihr Gehäuse, mit einer sich nach oben erstreckenden Gehäuseerweiterung für die Aufnahme von Geräten verbunden sein.

Zweckmäßig weist die Gehäuseerweiterung Einrichtungen zur Befestigung am vertikalen Schenkel des erwähnten Zählerkreuzes der Zählerplatzbaugruppe auf.

Die Erfindung wird nachfolgend anhand von Ausführungsbeispielen und der beiliegenden, sich auf diese Ausführungsbeispiele beziehenden Zeichnungen weiter erläutert. Es zeigen:
- Fig. 1: eine Anschlussvorrichtung für einen Stromzähler nach der Erfindung in schematischer Darstellung in Draufsicht,
- Fig. 2: die Anschlussvorrichtung nach Fig. 1 an einem Zählerplatz,
- Fig. 3: eine weitere erfindungsgemäße Anschlussvorrichtung in schematischer Darstellung in Draufsicht,
- Fig. 4: eine weitere erfindungsgemäße Anschlussvorrichtung in schematischer Darstellung in Draufsicht,
- Fig. 5: eine Tragplatte der Anschlussvorrichtung nach Fig. 3 in Draufsicht,
- Fig. 6: eine Anschlussvorrichtung nach der Erfindung mit angeschlossenem Stromzähler, die am Zählerkreuz einer Zählerplatzbaugruppe für einen herkömmlichen elektromechanischen Stromzähler montiert ist,
- Fig. 7: die in Fig. 6 enthaltene Anschlussvorrichtung mit aufgesetztem Stromzähler,
- Fig. 8: einen Innenraum eines Gehäuses der Befestigungs- und Kontaktiervorrichtung nach Fig. 6 und 7,
- Fig. 9: ein alternatives Gehäuse einer erfindungsgemäßen Befestigungs- und Kontaktiervorrichtung,
- Fig. 10: eine der Befestigungs- und Kontaktiervorrichtung von Fig. 6 und 7 entsprechende Befestigungs- und Kontaktiervorrichtung mit einer Gehäuseerweiterung,
- Fig. 11: die Befestigungs- und Kontaktiervorrichtung von Fig. 10 mit einem in der Gehäuseerweiterung zusätzlich angeordneten Gerät,
- Fig. 12: die Befestigungs- und Kontaktiervorrichtung von Fig. 10 mit zusätzlichem Gerät und einer plombierbaren Abdeckung der Gehäuseerweiterung,
- Fig. 13: eine Befestigungs- und Kontaktiervorrichtung nach der Erfindung, die in einem Kleinverteiler auf einer Hutprofilschiene montiert ist,
- Fig. 14: den Kleinverteiler mit auf die Befestigungs- und Kontaktiervorrichtung aufgesetztem Stromzähler und aufgesetzter Abdeckung,
- Fig. 15: eine gesonderte Darstellung der Inneneinbauten des Gehäuses von Fig. 8,
- Fig. 16: den zum Anschluss an die Befestigungs- und Kontaktiervorrichtung nach der Erfindung vorgesehenen Stromzähler in einer Ansicht schräg von unten,
- Fig. 17: eine der Vorrichtung von Fig. 10 ähnliche, komplett mit einem Stromzähler, einem Zusatzgerät und einer Abdeckung bestückte Befestigungs- und Kontaktiervorrichtung,
- Fig. 18: die komplett bestückte Befestigungs- und Kontaktiervorrichtung von Fig. 17 mit einer Blindplatte unter dem Stromzähler,
- Fig. 19: einen abnehmbaren Abschnitt der Befestigungs- und Kontaktiervorrichtung von Fig. 17 und 18, und
- Fig. 20: den abnehmbaren Teil von Fig. 19 bestückt mit einer Abdeckung und einem SLS-Schalter.

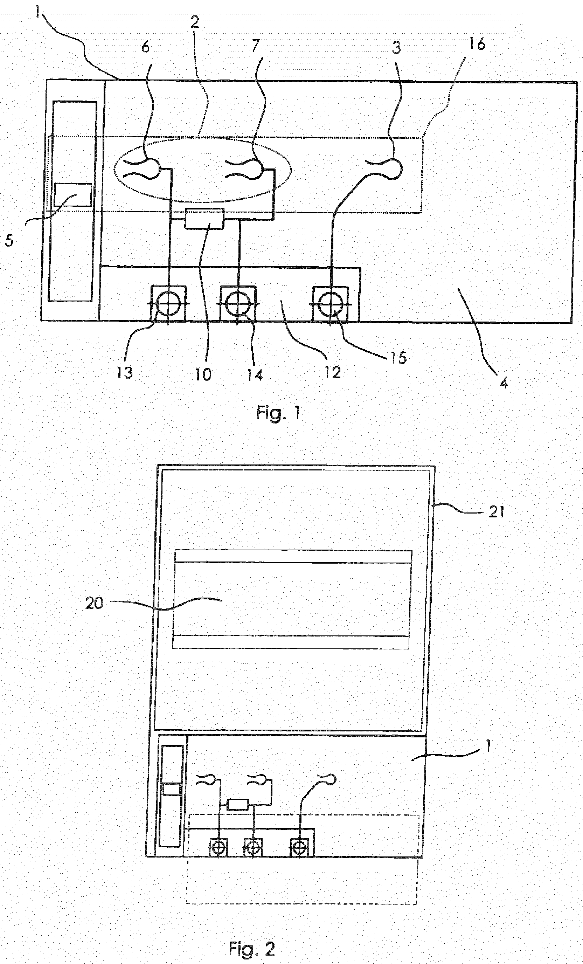

Fig. 1 zeigt eine erfindungsgemäße Anschlussvorrichtung 1 zur Verwendung bei Stromversorgung mit Einphasenwechselstrom. Sie umfasst ein Gehäuse 4 mit einer hier nicht gezeigten Tragplatte zur Aufnahme eines Stromzählers. Die Tragplatte ist mit Öffnungen versehen, durch die Kontaktstücke des Stromzählers zu einem Stromphasenanschlusselement 2 und einem Neutralleiteranschlusselement 3 geführt werden können. Außerdem kann sie eine Datenschnittstelle 5 aufnehmen.

Das Stromanschlusselement 2 weist ein stromzu- und einem stromabführendes Anschlussteil 6,7 auf. Die beiden Anschlussteile 6,7 sind über je eine Anschlussklemme 13,14 einer Kontaktleiste 12 mit einer Stromphase des Einphasenwechselstroms verbunden. Die Anschlussklemmen 13,14 lassen sich über ein Überbrückungsteil 10 überbrücken. Das Neutralleiteranschlusselement 3 ist über eine Anschlussklemme 15 mit dem Neutralleiter verbunden.

In der Anschlussvorrichtung 1 sind die Datenschnittstelle 5, das Stromphasenanschlusselement 2 und das Neutralleiteranschlusselement 3 etwa entlang einer Linie innerhalb eines gedachten und durch eine gestrichelte Linie gezeigten länglichen Raumabschnitts 16 angeordnet. Dies ermöglicht es, die Anschlussvorrichtung 1 in einer schmalen und länglichen Form aufzubauen und zu ihr passend mit einem ebenfalls schmalen und länglichen Stromzähler zu versehen.

Zwischen der Tragplatte und den Anschlusseinrichtungen 2,3 und der Datenschnittstelle 5 ist an die Tragplatte anliegend auf deren Innenseite eine hier nicht gezeigte verschiebbare Schieberplatte angeordnet. Ein Mechanismus zur Verschiebung der Schieberplatte und sein Zusammenwirken mit den Kontaktelementen des Stromzählers ist in der DE 10 2004 002 856 A1 beschrieben, auf die hier Bezug genommen wird. Ferner kann das Überbrückungsteil, wie ebenfalls in der DE 10 2004 002 856 A1 beschrieben durch die Schieberplatte in eine Überbrückungs- oder eine Offenstellung gebracht werden.

Wie durch die tulpenförmige Gestaltung der Anschlusselemente 6,7,3 angedeutet ist, lässt sich der Stromzähler, wenn seine Kontaktstücke durch die Öffnungen in der Tragplatte geführt sind und er auf der Tragplatte aufsitzt in Längsrichtung der Anschlussvorrichtung 1 nach rechts in eine Position verschieben, in der die Kontaktstücke in elektrischem Kontakt mit den Anschlusselementen 6,7,3 sind, und in umgekehrter Richtung wieder aus dieser Position bewegen. Bei einer solchen Bewegungsrichtung zur Kontaktierung des Stromzählers muss in Richtung senkrecht zu der Verschiebungsrichtung neben der Anschlussvorrichtung 1 kein Raum vorgesehen sein, der eine Bewegung des Stromzählers erlaubt. Der Raum kann entsprechend z.B. zur Aufnahme von Geräten genutzt werden.

Alternativ kann der Stromzähler auf der Tragplatte aber auch von links nach rechts oder in einer dazu senkrechten Richtung nach oben oder nach unten verschiebbar sein. Die Anschlusselemente 6,7,3 sind dann in einer entsprechend um 90° oder 180 ° verdrehten Position in der Anschlussvorrichtung 1 angeordnet.

Fig. 2 zeigt eine Anordnung der Anschlussvorrichtung nach Fig. 1 an einem zur Aufnahme von Zählern und/oder Steuergeräten, Klemmen, Überstromschutzeinrichtungen oder dergleichen vorgesehenen Zählerplatz mit einer Hutschiene 20 und einem Gehäuse 21 des Zählerplatzes.

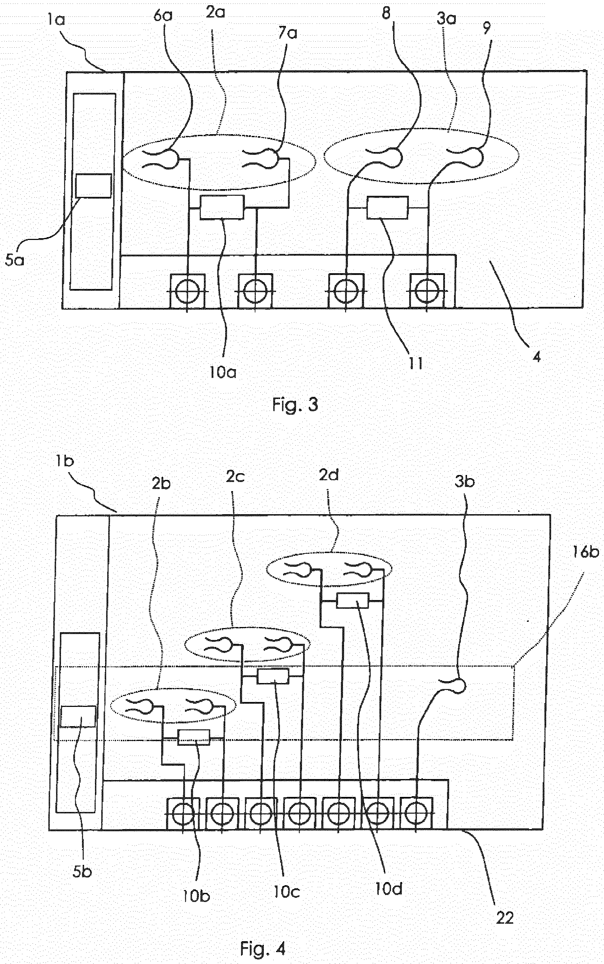

Es wird nun auf die Fig. 3 bis 8 Bezug genommen, wo gleiche oder gleichwirkende Teile mit derselben Bezugszahl wie in Fig. 1 bezeichnet sind und der betreffenden Bezugszahl jeweils ein Buchstabe beigefügt ist.

Eine in Fig. 3 gezeigte weitere erfindungsgemäße Anschlussvorrichtung 1a unterscheidet sich von derjenigen nach Fig. 1 dadurch, dass auch ein Neutralleiteranschlusselement 3a stromzu- und stromabführende Anschlussteile 8,9 aufweist. Die zu den Anschlussteilen 8,9 führenden Leitungen lassen sich wie oben beschrieben durch ein Überbrückungsteil 11 kurzschließen.

In Fig. 4 ist eine weitere erfindungsgemäße Anschlussvorrichtung 1 b gezeigt, die zur Nutzung mit Einphasenwechselstrom oder mit Dreiphasenwechselstrom vorgesehen ist.

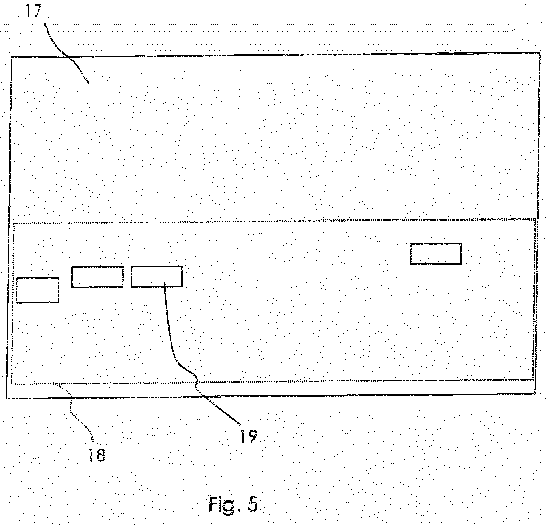

Eine Datenschnittstelle 5b, ein Stromphasenanschlusselement 2b und ein Neutralleiteranschlusselement 3b sind unterhalb einer in Fig.5 gezeigten Tragplatte 17 innerhalb eines durch eine gestrichelte Linie dargestellten, gedachten länglichen Raumabschnitts 16b angeordnet, während die Stromphasenanschlusselemente 2c, 2d in einem Raumbereich angeordnet sind, der außerhalb des Raumabschnitts 16b liegt.

Es kann also wahlweise ein Stromzähler, der z.B. auf der in Fig. 1 gezeigten Anschlussvorrichtung verwendet werden kann, zur Messung des Energieverbrauchs bei Versorgung mit Einphasenwechselstrom oder ein mit Kontaktstücken für drei Stromphasenanschlusselemente versehener Stromzähler verwendet werden, um den Energieverbrauch bei Versorgung mit Dreiphasenwechselstrom zu bestimmen.

Die Datenschnittstelle 5b, die Stromphasenanschlusselemente 2b und das Neutralleiteranschlusselement 3b können näher als in Fig. 4 gezeigt an einer Seite 22 der Anschlussvorrichtung 1 b angeordnet sein.

Wird die Anschlussvorrichtung 1 b an Einphasenwechselstrom betrieben, wird mit einem in Fig. 5 durch ein gestricheltes Rechteck angedeuteten Stromzähler 18 lediglich die Datenschnittstelle 5b, das Stromphasenanschlusselement 2b und das Neutralleiteranschlusselement 3b kontaktiert, während die Stromphasenanschlusselemente 2c,2d nicht benötigt werden. In diesem Fall kann, wie in Fig. 5 gezeigt, die Tragplatte 17 lediglich mit Öffnungen 19 an den Positionen der Datenschnittstelle 5b, des Stromphasenanschlusselements 2b und des Neutralleiteranschlusselements 3b versehen und an den Positionen der Stromphasenanschlusselemente 2c,2d geschlossen sein. Der Raum oberhalb des Stromzählers 18 ist frei und kann zur Aufnahme anderer Geräte verwendet werden.

Wird die Anschlussvorrichtung 1 b dagegen mit Dreiphasenwechselstrom genutzt, sind auch an den Positionen der Stromphasenanschlusselemente 2c,2d in der Tragplatte 17 Öffnungen vorgesehen, durch die Kontaktstücke eines zur Kontaktierung der drei Stromphasen geeigneten Stromzählers geführt werden können. Dieser Stromzähler ist entsprechend größer als der für die Messung von Einphasenwechselstrom bestimmte Stromzähler.

In einem hier nicht gezeigten Ausführungsbeispiel können die Datenschnittstelle, das Stromphasenanschlusselement und das Neutralleiteranschlusselement auch in einem Eckbereich der Anschlussvorrichtung angeordnet sein. Auch bei einer solchen Anordnung lassen sich die Anschlusseinrichtungen und die Datenschnittstelle beim Betrieb mit Einphasenwechselstrom mit einem verhältnismäßig kleinen Stromzähler kontaktieren. Dieser deckt lediglich den Eckbereich und nicht die gesamte Anschlussvorrichtung ab.

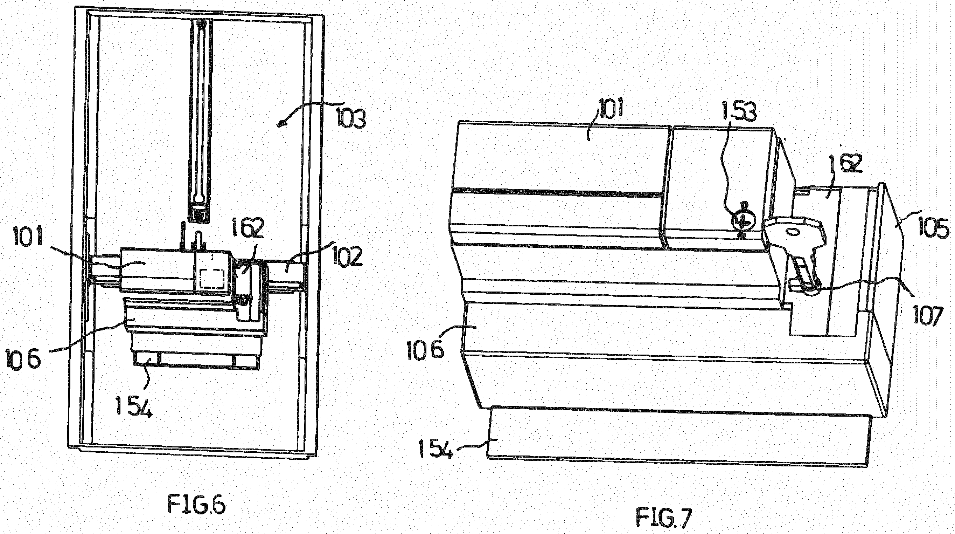

Eine als Befestigungs- und Kontaktiervorrichtung bezeichnete Vorrichtung zum Anschluss eines einphasigen elektronischen Stromzählers 101 lässt sich, wie in Fig. 6 gezeigt, am horizontalen Schenkel 102 eines Zählerkreuzes einer Zählerplatzbaueinheit 103 befestigen. Die Zählerplatzbaueinheit 103 diente vordem zur Aufnahme eines herkömmlichen elektromechanischen Stromzählers.

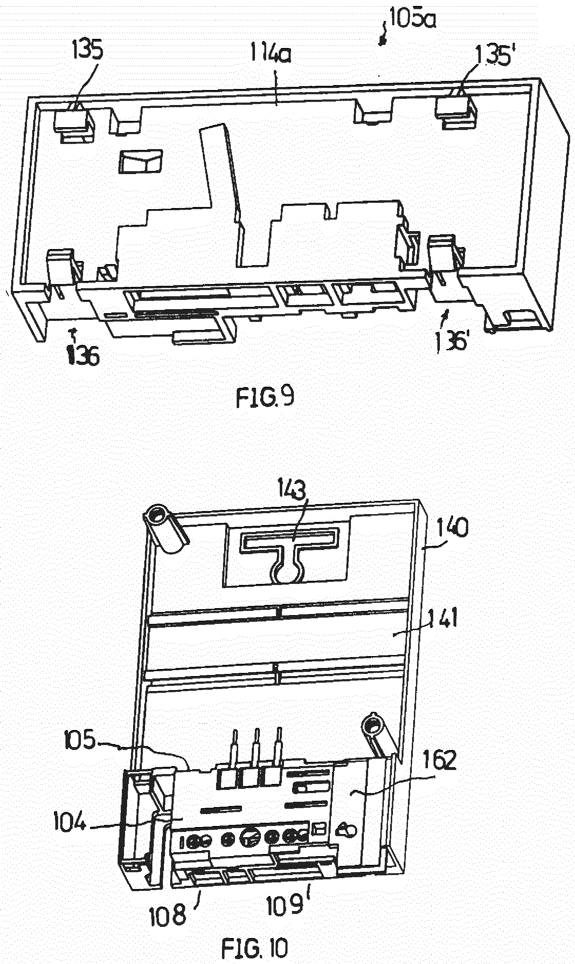

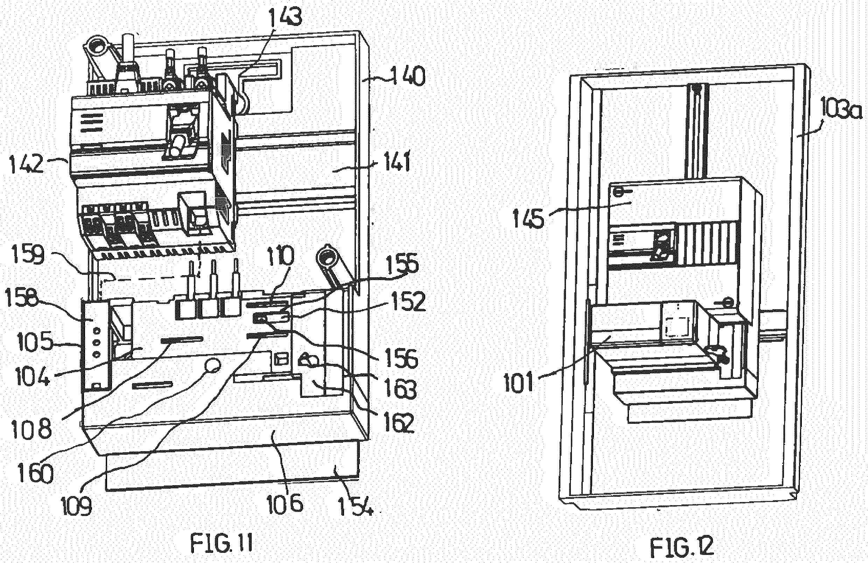

Der in Fig. 6 und 7 gezeigte elektronische Stromzähler 101 ist auf eine in Fig. 10 und 11 sichtbare Zählertragplatte 104 aufgesetzt, die eine Abdeckung eines länglichen Gehäuses 105 der Befestigungs- und Kontaktiervorrichtung bildet. Mit dem Gehäuse 105 ist eine Abdeckung 106 für der Befestigungs- und Kontaktiervorrichtung von unten zugeführte Stromkabel (nicht gezeigt) verbunden. Ein Steckschloss 107 und ein plombierbarer Bolzen 153 sichern den Verbleib des Stromzählers 1 in seiner in Fig. 6 und 7 gezeigten Anschlussposition.

Die durch den Stromzähler in ihrer Position gesicherte Abdeckung 106 weist eine abbrechbare Schürze 154 auf, die im Bedarfsfall der vollständigen Abdeckung einer Öffnung für die Zuführung der Stromkabel dient.

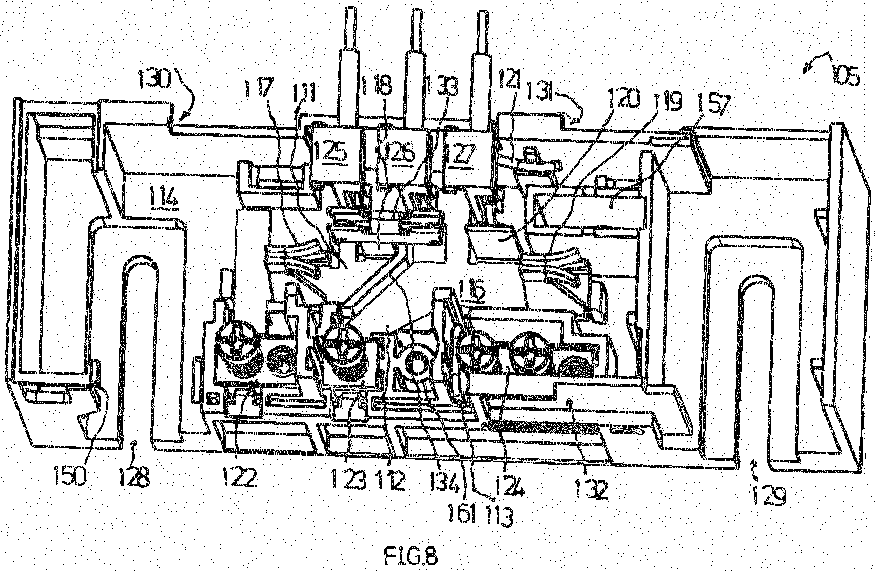

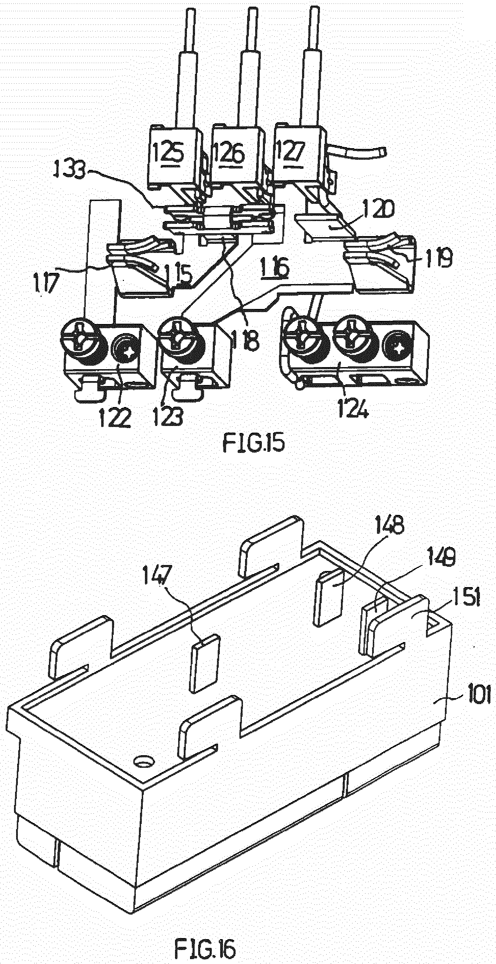

Wie die Fig. 10 und 11 erkennen lassen, weist die Zählertragplatte 104 Schlitzöffnungen 108 bis 110 auf, durch die hindurch von dem Stromzähler 101 vorstehende, in Fig. 16 sichtbare Kontaktelemente 147,148 und 149 in einen in Fig. 8 dargestellten Innenraum des Gehäuses 105 ragen. Die beiden, in Längsrichtung des Gehäuses 105 auf einer Linie angeordneten Schlitzöffnungen 108 und 109 nehmen die spannungsführenden Kontaktelemente 147 und 148 des einphasigen Stromzählers 101 auf. Durch die Schlitzöffnung 10 hindurch ragt das Kontaktelement 149 zur Verbindung mit dem Neutralleiter.

Wie Fig. 8 erkennen lässt, sind im Innenraum des länglichen Gehäuses 105 Anschlusselemente 111 bis 113 zur elektrischen Verbindung mit den vom Stromzähler 101 vorstehenden Kontaktelementen 147 bis 149 angeordnet. Die aus gebogenen Blechstanzteilen hergestellten Anschlusselemente 111 und 112 weisen jeweils eine durch Bodenvorsprünge gegen Verschiebung auf dem Gehäuseboden 114 gesicherte Grundplatte auf, von der Kontaktfahnen abgewinkelt sind. Durch Abwinklungen von der Grundplatte 115 des Anschlusselements 111 sind eine Anschlussklemme 117 mit tulpenartig aufgespreizten Kontaktfahnen sowie ein Kontaktschenkel 118 gebildet. Abwinklungen von der Grundplatte 116 des Anschlusselements 112 bilden eine der Anschlussklemme 117 entsprechende Anschlussklemme 119 sowie einen Kontaktschenkel 120. Ein durchgehender, vom Gehäuseboden 114 vorspringender Steg 134 sorgt für eine Festlegung der Grundplatten 115,116 auf dem Gehäuseboden sowie für eine isolierende elektrische Trennung der Anschlusselemente 111, 112.

Abweichend von den Anschlusselementen 111 und 112 ist das Anschlusselement 113 durch ein in dem Gehäuse 105 festgelegtes Drahtstück mit einem der Kontaktierung dienenden Endabschnitt 121 gebildet. Die Anschlussklemmen 117, 119 der Anschlusselemente 111, 112 führen Spannung. Das Anschlusselement 113 bildet den Neutralleiter. Die Anschlusselemente 111 bis 113 führen jeweils zu einer Schraubklemme 122,123 bzw. 124, über die entsprechende Stromkabel an die Befestigungs- und Kontaktiereinrichtung anschließbar sind. Über weitere, mit den Anschlusselementen 111 bis 113 verbundene Klemmen 125 bis 127 lassen sich Spannungen zur Energieversorgung von Zusatzgeräten abgreifen.

Vertikale Einschlitzungen 128 und 129 im Boden 114 des Gehäuses 105 dienen der Befestigung des Gehäuses 105 an dem horizontalen Schenkel 102 des Zählerkreuzes (Fig. 6). An einander gegenüberliegenden Längsseitenwänden des Gehäuses 5 sind hinterschnittene Taschen 30,31,32 und 50 gebildet, in welche vier von dem Stromzähler 1 vorstehende, in Fig. 11 gezeigte Hakenelemente 51 eingreifen.

Eine in Fig. 10 und 11 sichtbare Öffnung 155 in der Zählertragplatte 104 dient der Verschiebung einer unter der Zählertragplatte 104 angeordneten Schieberplatte 152. Zur Verschiebung ist ein Hebelwerkzeug durch die Öffnung 155 und eine Öffnung 156 in der Schieberplatte 152 einführbar. Ein kastenartiger Vorsprung 57 am Gehäuseboden 114 (Fig. 8) bildet einen Gegenhalter sowie eine Isolation für das Hebelwerkzeug.

Zum Anschluss des Stromzählers 101 an die Befestigungs- und Kontaktiervorrichtung wird der Stromzähler 101 auf die Zählertragplatte 104 aufgesetzt, wobei die genannten Hakenelemente in die hinterschnittenen Taschen 130 bis 132 und 150 eingreifen. Die vom Stromzähler 151 vorstehenden Kontaktelemente 147 bis 149 ragen in den Innenraum des Gehäuses 105. Durch Verschiebung des Stromzählers 101 auf der Zählertragplatte 104 in Längsrichtung des Gehäuses 105 nach links kommen die betreffenden Kontaktelemente mit den Anschlussklemmen 117,119 der Anschlusselemente 111, 112 sowie mit dem Endabschnitt 121 des aus Draht hergestellten Anschlusselements 113 in Kontakt. Gleichzeitig wird durch die unter der Zählertragplatte 104 angeordnete und zusammen mit dem Stromzähler 101 bewegte Schieberplatte 152 eine Brücke 133 verschoben und dadurch eine elektrische Überbrückungsverbindung zwischen den durch Abwinklung gebildeten Kontaktschenkeln 118 und 120 gelöst. Der Stromzähler 101 befindet sich damit in seiner Anschlussposition, aus der er bei geschlossenem Steckschloss 107 nicht entfernt werden kann. Zur Sicherung des Stromzählers in seiner Anschlussposition dient ferner der plombierbare Bolzen 153.

Der gesicherte Stromzähler sichert auch die Abdeckung 106, die eine Öffnung 160 (Fig. 11) aufweist, durch die ein nach innen gerichteter Vorsprung gebildet ist, der in eine vom Gehäuseboden 114 vorspringende Hülse 161 (Fig. 8) eingreift und so am Gehäuse 105 festgelegt ist. In der Hülse kann ein Gewinde für eine Arretierungsschraube gebildet sein, die eine Verschiebung des Stromzählers in Längsrichtung der Trägerschiene des Zählerkreuzes oder der Hutprofilschiene verhindert.

Die durch den Stromzähler 101 gesicherte Abdeckung 106 sichert wiederum eine einschiebbare Platte 162 mit einer Aufnahme 163 für das Steckschloss 107.

Fig. 9 zeigt eine alternative Ausführungsform zum Gehäuse 105. Bei einem Gehäuse 105a sind anstelle von Einschlitzungen 128,129 am Gehäuseboden 114a außenseitig Verhakungselemente 135,136 bzw. 135',136' zur Befestigung des Gehäuses 105a an einer Hutprofilschiene gebildet.

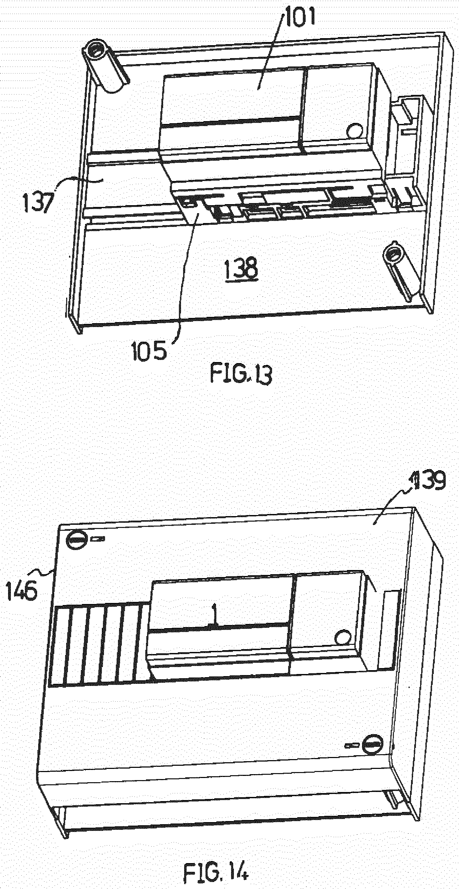

Gemäß Fig. 13 und 14 kann eine solche Hutprofilschiene 137 z.B. auf dem Boden 138 eines die Befestigungs- und Kontaktiervorrichtung aufnehmenden Kleinverteilers 139 mit einer plombierbaren Abdeckung 146 gebildet sein.

Wie aus den Fig. 10 bis 11 hervorgeht, lässt sich das Gehäuse 105 nach oben erweitern. Insbesondere kann es einstückig mit einer Gehäuseerweiterung 140 verbunden sein, in der z.B. auf einer Hutprofilschiene 141 montierte Geräte untergebracht werden können, die sich bei Bedarf über die Klemmen 125 bis 127 mit einer Betriebsspannung versorgen lassen. Fig. 11 zeigt beispielhaft die Unterbringung eines Schutz- oder Kommunikationsgerätes 142. Die Gehäuseerweiterung 140 weist bei 143 einen Durchbruch für die Verbindung mit dem vertikalen Schenkel 144 eines Zählerkreuzes auf, wie dies in Fig. 12 gezeigt ist.

In Fig. 11 weist das Bezugszeichen 158 auf eine Datenschnittstelle für den Datenaustausch zwischen dem Stromzähler 101 und dem Kommunikationsgerät 142 über eine Leitung 159 hin.

Die Gehäuseerweiterung 140 kann gemäß Fig. 12 mit einer plombierbaren Abdeckung 145 versehen sein.

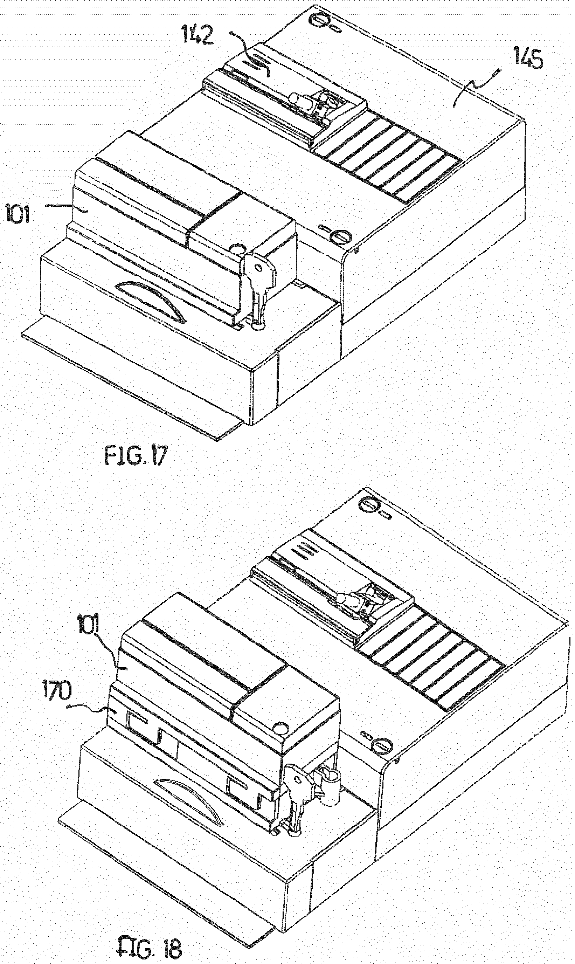

Fig. 17 zeigt eine komplett mit dem Stromzähler 101, einem Zusatzgerät in Form eines Kommunikationsgerätes 142 und der Abdeckung 145 bestückte Befestigungs- und Kontaktiereinrichtung. In Fig. 18, in der die gleichen Teile wie in Fig. 17 dargestellt sind, ist der Stromzähler 101 durch eine Blindplatte 170 von der übrigen Befestigungs- und Kontaktiereinrichtung getrennt und die Befestigungs- und Kontaktiereinrichtung stillgelegt. Der Stromzähler befindet sich in einer Parkposition, in der er für einen Wiederanschluss verfügbar und zum Verbleib an Ort und Stelle durch eine Plombierung gesichert ist.

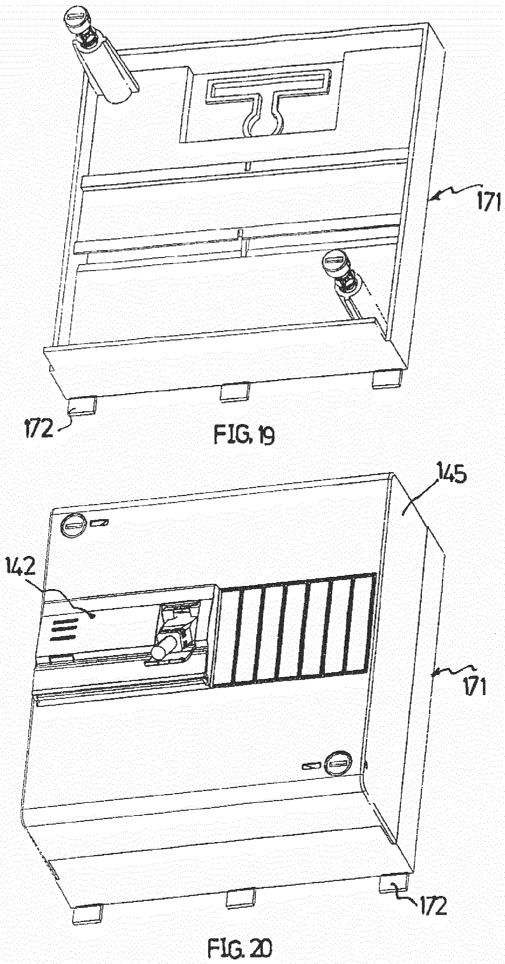

Anders als die in Fig. 11 und 12 gezeigte Befestigungs- und Kontaktiereinrichtung mit einer Gehäuseerweiterung 140 weist die in Fig. 17 und 18 gezeigte Befestigungs- und Kontaktiereinrichtung einen der Gehäuseerweiterung entsprechenden abnehmbaren, in Fig. 19 und 20 gezeigten Teil 171 auf. Über Steckfüße 172 ist der abnehmbare Teil 171 mit der übrigen Befestigungs- und Kontaktiereinrichtung verbindbar.

## Patentansprüche

1. Anschlussvorrichtung für einen Stromzähler, insbesondere einen elektronischen Stromzähler (101), die eine Befestigungs- und Kontaktiereinrichtung mit einem länglichen, eine Zählertragplatte (104) zur Aufnahme des Stromzählers (101) aufweisenden Gehäuse (4,105) umfasst, wobei in dem Gehäuse (4, 105) Anschlusselemente (2,67, 111, 112) für eine ein einzige oder mehrere Stromphasen zur elektrischen Verbindung mit von dem Stromzähler (101) durch Öffnungen (19, 108, 109) in der Zählertragplatte (104) vorstehenden Kontaktstücken (147,148) angeordnet sind,
**dadurch gekennzeichnet,**
**dass** in dem länglichen Gehäuse (4,105) ferner ein Anschlusselement (3, 113) für einen Neutralleiter und in der Trägerplatte (101) eine entsprechende Öffnung (110) für ein vom Stromzähler (101) vorstehendes Kontaktstück (149) vorgesehen ist, dass die Kontaktstücke (147-149) durch Verschiebung des Stromzählers (101) auf der Tragplatte (104) in Längsrichtung des Gehäuses (4,105) oder senkrecht dazu mit den Anschlusselementen (2,6,7,3,111-113) verbindbar sind, dass das längliche Gehäuse (4,105) Einrichtungen (128,129,135,136) zur Anbringung des länglichen Gehäuses (4,105) am horizontalen Schenkel (102) eines Zählerkreuzes einer Zählerplatzbaueinheit (103) oder an einer Hutprofilschiene (137) mit einer Längsseite parallel zu dem Schenkel (102) bzw. der Hutprofilschiene (137) aufweist und dass in der Alternative mit Anschluss-elementen für mehrere Stromphasen die Zählertragplatte jedoch nur Öffnungen zur Nutzung von Anschlusselementen einer einzigen Stromphase aufweist.

2. Anschlussvorrichtung nach Anspruch 1,
**dadurch gekennzeichnet,**
**dass** die Anschlusselemente (2) für die einzige Stromphase und das Neutralleiteranschlusselement (3) oder zumindest eines der mehreren Stromphasenanschlusselemente (2b) und das Neutralleiteranschlusselement (3b) in einem länglichen Raumabschnitt (16;16b) in Längsrichtung des Raumabschnitts (16;16b) gesehen hintereinander und/oder unter Freilassung eines
Raumbereichs der Anschlussvorrichtung zusammen an einer Seite oder in einem Eckbereich der Anschlussvorrichtung (1:1b) angeordnet sind.

3. Anschlussvorrichtung nach Anspruch 1 oder 2,
**dadurch gekennzeichnet,**
**dass** die Anschlussvorrichtung (1;1b) eine Datenschnittstelle (5;5b) zur Übertragung von Daten von oder zu dem Stromzähler aufweist und die Datenschnittstelle (5;5b) zusammen mit dem Stromphasenanschlusselement (2;2b) und dem Neutralleiteranschlusselement (3;3b), vorzugsweise im dem länglichen Raumabschnitt (16;16b) und/oder an der Seite (22) oder in dem Eckbereich, platzsparend angeordnet ist.

4. Anschlussvorrichtung nach einem der Ansprüche 1 bis 3,
**dadurch gekennzeichnet,**
**dass** das Stromphasenanschlusselement (2) und vorzugsweise das Neutralleiteranschlusselement (3) ein stromzu- und ein stromabführendes Anschlussteil (6,7) aufweist, wobei vorzugsweise die Anschlussteile (6,7) in der Längsrichtung und/oder in Richtung entlang der Seite gesehen hintereinander angeordnet sind.

5. Anschlussvorrichtung nach einem der Ansprüche 1 bis 4,
**dadurch gekennzeichnet,**
**dass** die Anschlusselemente (2) und ggf. mehrere Neutralleiteranschluss-elemente (3) mit einem Überbrückungsteil (10) versehen sind, das eine die Anschlussteile (6,7) überbrückende Stellung und eine Offenstellung aufweist.

6. Anschlussvorrichtung nach einem der Ansprüche 1 bis 5,
**dadurch gekennzeichnet,**
**dass** die Einrichtungen (128, 129; 135, 136) zur Anbringung der Befestigungs- und Kontaktiervorrichtung allein an dem horizontalen Schenkel (102) bzw. der Hutprofilschiene (137) vorgesehen sind.

7. Anschlussvorrichtung nach Anspruch 6,
**dadurch gekennzeichnet,**
**dass** die Einrichtungen zur Befestigung der Befestigungs- und Kontaktiereinrichtung an dem horizontalen Schenkel (102) vertikale Einschlitzungen (128,129) im Boden (114) des Gehäuses (105) umfassen.

8. Vorrichtung nach einem der Ansprüche 1 bis 7,
**dadurch gekennzeichnet,**
**dass** die Anschlusselemente (111-113) mit Klemmen (122-124) zur Verbindung der Befestigungs- und Kontaktiervorrichtung mit von unten zugeführten Stromkabeln in Verbindung stehen.

9. Vorrichtung nach einem der Ansprüche 1 bis 8,
**dadurch gekennzeichnet,**
**dass** die Anschlusselemente (111-113) ferner mit Klemmen (125-127) zur Verbindung der Befestigungs- und Kontaktiervorrichtung mit von oben zugeführten Leitungen zum Abgreifen von Spannungen in Verbindung stehen.

10. Vorrichtung nach einem der Ansprüche 1 bis 9,
**dadurch gekennzeichnet,**
**dass** wenigstens ein Teil der Anschlusselemente (111-113), insbesondere die spannungsführenden Anschlusselemente (111,112), eine am Boden (114) des Gehäuses (105) durch Bodenvorsprünge (134) gegen Verschiebung gesicherte Grundplatte (115, 116) mit Abwinklungen für die Bildung von Kontaktiereinrichtungen, insbesondere einer Anschlussklemme (117, 119) und eines Kontaktschenkels (118,120), aufweisen.

11. Vorrichtung nach einem der Ansprüche 1 bis 10,
**dadurch gekennzeichnet,**
**dass** ein Anschlusselement (113) für den Neutralleiter ein an dem Gehäuse
(105) festgelegtes Drahtstück umfasst, von dem vorzugsweise ein Endabschnitt
(121) zur Bildung einer mit dem betreffenden Kontaktelement des Stromzählers
(101) verbindbaren Kontaktfahne vorgesehen ist.

12. Vorrichtung nach einem der Ansprüche 1 bis 11,
**dadurch gekennzeichnet,**
**dass** der Stromzähler (101) auf der Befestigungs- und Kontaktiervorrichtung in deren Längsrichtung unter Verbindung der Kontaktelemente des Stromzählers (101) mit den Anschlusselementen (111-113) der Befestigungs- und Kontaktiervorrichtung verschiebbar ist.

13. Vorrichtung nach einem der Ansprüche 1 bis 12,
**dadurch gekennzeichnet,**
**dass** die Befestigungs- und Kontaktiervorrichtung, vorzugsweise einstückig über ihr Gehäuse (105), mit einer sich nach oben erstreckenden Gehäuseerweiterung (140) für die Aufnahme von Geräten (142) verbunden ist, wobei vorzugsweise die Gehäuseerweiterung (140) Einrichtungen (143) zur Befestigung am vertikalen Schenkel (144) des Zählerkreuzes der Zählerplatzbaugruppe (103) aufweist.

14. Stromzähler mit Mitteln für den Anschluss an eine Anschlussvorrichtung nach einem der Ansprüche 1 bis 13.

## Claims

1. Connector device for an electricity meter, in particular an electronic electricity meter (101), which comprises a securing and contacting device with an elongated housing (4, 105) comprising a meter support plate (104) for mounting the electricity meter (101), wherein in the housing (4, 105) connection elements (2, 67, 111, 112) are arranged for a single or multiple current phases for electrical connection with contact pieces (147, 148) projecting from the electricity meter (101) through openings (19, 108, 109) in the meter support plate (104),
**characterised in that**
in the elongated housing (4, 105) also a connection element (2, 113) is provided for a neutral line and a corresponding opening (110) in the support plate (101) for a contact piece (149) projecting from the electricity meter (101) is provided, **in that** the contact pieces (147-149) can be connected by displacement of the electricity meter (101) on the support plate (104) in longitudinal direction of the housing (4, 105) or perpendicular thereto to the connection elements (2, 6, 7, 3, 111-113), **in that** the elongated housing (4, 105) comprises devices (128, 129, 135, 136) for attaching the elongated housing (4, 105) on the horizontal arm (102) of a meter board of a meter space unit (103) or on a hat profile rail (137) with a longitudinal side parallel to the arm (102) or the hat profile rail (137) and **in that** in the alternative with connection elements for a plurality of current phases the meter support plate only has openings for using connection elements of a single current phase.

2. Connector device according to claim 1,
**characterised in that**
the connection elements (2) for the single current phase and the neutral line connection element (3) or at least one of the plurality of current phase connection elements (2b) and the neutral line connection element (3b) are arranged behind one another in an elongated section (16;16b), as viewed in longitudinal direction of the section (16; 16b), and/or are arranged together on one side or in a corner area of the connector device (1 ;1 b), leaving an area of the connector device.

3. Connector device according to claim 1 or 2,
**characterised in that**
the connector device (1:1 b) has a data interface (5;5b) for transmitting data from or to the electricity meter and the data interface (5;5b) is arranged in a space-saving manner together with the current phase connection element (2;2b) and the neutral line connection element (3;3b), preferably in the elongated section (16;16b) and/or on the side (22) or in the corner area.

4. Connector device according to any one of claims 1 to 3,
**characterised in that**
the current phase connection element (2) and preferably the neutral line connection element (3) has a current supplying and current transmitting connection part (6, 7), wherein preferably the connecting parts (6,7) are arranged behind one another, as viewed in longitudinal direction and/or in a direction along the side.

5. Connector device according to any one of claims 1 to 4,
**characterised in that**
the connection elements (2) and possibly a plurality of neutral line connection elements (3) are provided with a bridging part (10) which has a position bridging the connection parts (6,7) and an open position.

6. Connector device according to any one of claims 1 to 5,
**characterised in that**
the devices (128,129;135,136) for attaching the securing and contacting device are provided only on the horizontal arm (102) or the hat profile rail (137).

7. Connector device according to claim 6,
**characterised in that**
the devices for securing the securing and contacting device on the horizontal arm (102) comprise vertical slits (128,129) in the base (114) of the housing (105).

8. Device according to any one of claims 1 to 7,
**characterised in that**
the connection elements (111-113) are connected to clamps (122-124) for connecting the securing and contacting device to power cables supplied from below.

9. Device according to any one of claims 1 to 8,
**characterised in that**
the connection elements (111-113) are also connected to clamps (125-127) for connecting the securing and contacting device to lines supplied from above for tapping voltage.

10. Device according to any one of claims 1 to 9,
**characterised in that**
at least a portion of the connection elements (111-113), in particular the voltage-carrying connection elements (111, 112), comprise a base plate (115, 116) secured against displacement on the base (114) of the housing (105) by base projections (134) with angles for the formation of contacting devices, in particular a connection clamp (117,119) and a contact arm (118,120).

11. Device according to any one of claims 1 to 10,
**characterised in that**
a connection element (113) for the neutral line comprises a piece of wire fixed to the housing (105), preferably one end section (121) of the piece of wire being provided for forming a contact tab which can be connected to the relevant contact element of the electricity meter (101).

12. Device according to any one of claims 1 to 11,
**characterised in that**
the electricity meter (101) on the securing and contacting device can be displaced in its longitudinal direction with the connection of the contact elements of the electricity meter (101) to the connection elements (111-113) of the securing and contacting device.

13. Device according to any one of claims 1 to 12
**characterised in that**
the securing and contacting device is preferably connected in one piece via its housing (105) to an upwardly extending housing extension (140) for holding devices (142), wherein preferably the housing extension (140) comprises devices (143) for securing onto the vertical arm (144) of the meter board of the meter assembly (103).

14. Electricity meter comprising means for connecting to a connection device according to any one of claims 1 to 13.

## Revendications

1. Dispositif de raccordement pour un compteur d'électricité, en particulier un compteur d'électricité électronique (101), qui comprend un dispositif de fixation et de contact avec un boîtier allongé (4, 105), présentant une plaque-support de compteur (104) destinée à recevoir le compteur d'électricité (101), des éléments de raccordement (2, 67, 111, 112) pour une seule ou plusieurs phases de courant, destinés à la connexion électrique avec des pièces de contact (147, 148) faisant saillie du compteur d'électricité (101) à travers des ouvertures (19, 108, 109) dans la plaque-support de compteur (104), étant disposés dans le boîtier (4, 105),
**caractérisé en ce**
**que** dans le boîtier allongé (4, 105) est en outre prévu un élément de raccordement (3, 113) pour un conducteur neutre et une ouverture correspondante (110) dans la plaque-support (101) pour une pièce de contact (149) faisant saillie du compteur d'électricité (101), que les pièces de contact (147-149) peuvent être connectées aux éléments de raccordement (2, 6, 7, 3, 111-113) par coulissement du compteur d'électricité (101) sur la plaque-support (104) dans la direction longitudinale du boîtier (4, 105) ou perpendiculairement à celle-ci, que le boîtier allongé (4, 105) présente des moyens (128, 129, 135, 136) pour le montage du boîtier allongé (4, 105) sur la branche horizontale (102) d'une croix de compteur d'un ensemble panneau de compteur (103) ou sur un rail profilé chapeau (137), avec un grand côté parallèle à la branche (102) ou au rail profilé chapeau (137) et que dans le cas d'éléments de raccordement pour plusieurs phases de courant, la plaque-support de compteur ne présente que des ouvertures destinées à l'utilisation d'éléments de raccordement d'une phase de courant unique.

2. Dispositif de raccordement selon la revendication 1,
**caractérisé en ce**
**que** les éléments de raccordement (2) pour la phase de courant unique et l'élément de raccordement de conducteur neutre (3) ou au moins un des plusieurs éléments de raccordement de phase de courant (2b) et l'élément de raccordement de conducteur neutre (3b) sont disposés dans une partie spatiale allongée (16 ; 16b), l'un derrière l'autre vu dans la direction longitudinale de la partie spatiale (16 ; 16b), et/ou, en laissant libre une zone spatiale du dispositif de raccordement, ensemble sur un côté ou dans une zone de coin du dispositif de raccordement (1 ; 1b).

3. Dispositif de raccordement selon la revendication 1 ou la revendication 2,
**caractérisé en ce**
**que** le dispositif de raccordement (1 ; 1b) présente une interface de données (5 ; 5b) pour la transmission de données de ou vers le compteur d'électricité et l'interface de données (5 ; 5b) est disposée de manière peu encombrante avec l'élément de raccordement de phase de courant (2 ; 2b) et l'élément de raccordement de conducteur neutre (3 ; 3b) de préférence dans la partie spatiale allongée (16 ; 16b) et/ou sur le côté (22) ou dans la zone de coin.

4. Dispositif de raccordement selon l'une des revendications 1 à 3,
**caractérisé en ce**
**que** l'élément de raccordement de phase de courant (2) et de préférence l'élément de raccordement de conducteur neutre (3) présentent une partie de raccordement d'entrée et de sortie de courant (6, 7), les parties de raccordement (6, 7) étant de préférence disposées l'une derrière l'autre dans la direction longitudinale et/ou dans la direction suivant le côté.

5. Dispositif de raccordement selon l'une des revendications 1 à 4,
**caractérisé en ce**
**que** les éléments de raccordement (2) et le cas échéant plusieurs éléments de raccordement de conducteur neutre (3) sont pourvus d'une partie de pontage (10) qui présente une position pontant les parties de raccordement (6, 7) et une position ouverte.

6. Dispositif de raccordement selon l'une des revendications 1 à 5,
**caractérisé en ce**
**que** les moyens (128, 129 ; 135, 136) pour le montage du dispositif de fixation et de contact sont prévus seulement sur la branche horizontale (102) ou le rail profilé chapeau (137).

7. Dispositif de raccordement selon la revendication 6,
**caractérisé en ce**
**que** les moyens de fixation du dispositif de fixation et de contact sur la branche horizontale (102) comprennent des entailles verticales (128, 129) dans le fond (114) du boîtier (105).

8. Dispositif selon l'une des revendications 1 à 7,
**caractérisé en ce**
**que** les éléments de raccordement (111-113) sont reliés à des bornes (122-124) destinées à la connexion du dispositif de fixation et de contact à des câbles électriques amenés par le bas.

9. Dispositif selon l'une des revendications 1 à 8,
**caractérisé en ce**
**que** les éléments de raccordement (111-113) sont en outre reliés à des bornes (125-127) destinées à la connexion du dispositif de fixation et de contact à des lignes de prélèvement de tensions amenées par le haut.

10. Dispositif selon l'une des revendications 1 à 9,
**caractérisé en ce**
**qu'**au moins une partie des éléments de raccordement (111-113), en particulier les éléments de raccordement sous tension (111, 112), présentent une plaque de base (115, 116) assurée contre le coulissement sur le fond (114) du boîtier (105) par des saillies de fond (134) et pourvue de parties coudées pour former des moyens de contact, en particulier une borne de raccordement (117, 119) et une branche de contact (118, 120).

11. Dispositif selon l'une des revendications 1 à 10,
**caractérisé en ce**
**qu'**un élément de raccordement (113) pour le conducteur neutre comprend un morceau de fil métallique fixé au boîtier (105), dont de préférence une partie d'extrémité (121) est prévue pour former une languette de contact pouvant être connectée à l'élément de contact concerné du compteur d'électricité (101).

12. Dispositif selon l'une des revendications 1 à 11,
**caractérisé en ce**
**que** le compteur d'électricité (101) peut coulisser sur le dispositif de fixation et de contact dans la direction longitudinale de celui-ci, entraînant la connexion des éléments de contact du compteur d'électricité (101) avec les éléments de raccordement (111-113) du dispositif de fixation et de contact.

13. Dispositif selon l'une des revendications 1 à 12
**caractérisé en ce**
**que** le dispositif de fixation et de contact est relié, de préférence d'une seule pièce par son boîtier (105), à une extension de boîtier (140) s'étendant vers le haut pour la réception d'appareils (142), l'extension de boîtier (140) présentant de préférence des moyens (143) pour la fixation à la branche verticale (144) de la croix de compteur de l'ensemble panneau de compteur (103).

14. Compteur d'électricité comprenant des moyens pour le raccordement à un dispositif de raccordement selon l'une des revendications 1 à 13.
